(19) Europäisches Patentamt
European Patent Office
Office européen des brevets

(11) **EP 3 640 589 A1**

(12) **EUROPÄISCHE PATENTANMELDUNG**

(43) Veröffentlichungstag:
**22.04.2020   Patentblatt 2020/17**

(51) Int Cl.:
*G01C 15/00* (2006.01)        *G01S 17/02* (2020.01)
*G06F 17/50* (2006.01)        *G06K 9/00* (2006.01)
*G06T 19/00* (2011.01)

(21) Anmeldenummer: **18020521.3**

(22) Anmeldetag: **21.10.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Hilti Aktiengesellschaft**
**9494 Schaan (LI)**

(72) Erfinder:
• **GLOOR, Thomas**
  **9495 Triesen (LI)**
• **KLUG, Christoph**
  **4432 Ernsthofen (AT)**
• **ARTH, Clemens**
  **8111 Gratwein-Strassengel (AT)**

(74) Vertreter: **Hilti Aktiengesellschaft**
**Corporate Intellectual Property**
**Feldkircherstrasse 100**
**Postfach 333**
**9494 Schaan (LI)**

(54) **VERFAHREN ZUM REGISTRIEREN EINER TOTALSTATION IM BEZUGSSYSTEM EINES CAD-MODELLS**

(57)   Verfahren zum Registrieren einer Totalstation (10), die in einer Messumgebung (11) mit einem oder mehreren Objekten (14, 15, 16, 17, 18) aufgestellt ist, im Bezugssystem eines CAD-Modells, welches die Objekte (14, 15, 16, 17, 18) der Messumgebung (11) abbildet, durch eine Kontrolleinrichtung (13).

FIG. 1

## Beschreibung

Die Erfindung betrifft ein Verfahren zum Registrieren einer Totalstation im Bezugssystem eines CAD-Modells gemäß dem Oberbegriff des Anspruchs 1.

## Stand der Technik

Totalstationen sind Vermessungsgeräte, die über Winkel- und Distanzmesseinheiten verfügen und Winkel- und Distanzmessungen zu ausgewählten Zielobjekten erlauben. Die Winkel- und Distanzmesswerte werden im Bezugssystem der Totalstation gemessen und müssen für eine absolute Positionsbestimmung noch mit einem äußeren Bezugssystem verknüpft werden.

Bei bekannten Verfahren zum Registrieren einer Totalstation in einem äußeren Bezugssystem werden Zielobjekte an bekannten Kontrollpunkten positioniert und die Koordinaten der Kontrollpunkte werden im Bezugssystem der Totalstation gemessen, die Koordinaten der Kontrollpunkte sind außerdem im äußeren Bezugssystem bekannt. Die Registrierung der Totalstation erfolgt mithilfe der Koordinaten der Kontrollpunkte im äußeren Bezugssystem und im Bezugssystem der Totalstation.

## Darstellung der Erfindung

Die Aufgabe der vorliegenden Erfindung besteht darin, die Registrierung einer Totalstation im Bezugssystem eines CAD-Modells dahingehend zu vereinfachen, dass die Registrierung der Totalstation ohne Kontrollpunkte mit bekannten Koordinaten möglich ist.

Diese Aufgabe wird bei dem eingangs genannten Verfahren erfindungsgemäß durch die Merkmale des unabhängigen Anspruchs 1 gelöst. Vorteilhafte Weiterbildungen sind in den abhängigen Ansprüchen angegeben.

Das Verfahren zum Registrieren einer Totalstation, die in einer Messumgebung mit einem oder mehreren Objekten aufgestellt ist, im Bezugssystem eines CAD-Modells, welches die Objekte der Messumgebung abbildet, durch eine Kontrolleinrichtung, umfasst erfindungsgemäß folgende Schritte:

- Auswahl von drei Flächen im CAD-Modell, wobei die Normalenvektoren der drei Flächen einen dreidimensionalen Raum aufspannen,
- Bestimmen einer ersten Ebenengleichung für eine erste Ebene, die eine erste Fläche der drei Flächen umfasst, einer zweiten Ebenengleichung für eine zweite Ebene, die eine zweite Fläche der drei Flächen umfasst, und einer dritten Ebenengleichung für eine dritte Ebene, die eine dritte Fläche der drei Flächen umfasst, im Bezugssystem des CAD-Modells durch die Kontrolleinrichtung,
- Ausrichten der Totalstation in der Messumgebung auf den Schnittpunkt der ersten, zweiten und dritten Ebene im CAD-Modell, wobei die Ausrichtung der Totalstation von der Kontrolleinrichtung als Startpose definiert wird,

- Rotieren der Totalstation um die Drehachse der Startpose und Ausführen von N verschiedenen Messungen während der Rotation der Totalstation, wobei bei jeder der N verschiedenen Messungen ein Horizontalwinkel von einer ersten Winkelmesseinheit, ein Vertikalwinkel von einer zweiten Winkelmesseinheit und eine Distanz von einer Distanzmesseinheit der Totalstation gemessen wird,
- Speichern von N verschiedenen Messpunkten mit Messkoordinaten, wobei die Messkoordinaten den Horizontalwinkel, den Vertikalwinkel und die Distanz umfassen,
- Zuordnen von K der N, $K \leq N$ verschiedenen Messpunkte zur ersten Ebene, zur zweiten Ebene oder zur dritten Ebene, wobei die der ersten Ebene zugeordneten Messpunkte als erste Messpunkte, die der zweiten Ebene zugeordneten Messpunkte als zweite Messpunkte und die der dritten Ebene zugeordneten Messpunkte als dritte Messpunkte von der Kontrolleinrichtung definiert werden,
- Bestimmen einer ersten Funktionsgleichung für die ersten Messpunkte, einer zweiten Funktionsgleichung für die zweiten Messpunkte und einer dritten Funktionsgleichung für die dritten Messpunkte im Bezugssystem der Totalstation durch die Kontrolleinrichtung,
- Bestimmen einer Zuordnung zwischen der ersten, zweiten und dritten Ebenengleichung im Bezugssystem des CAD-Modells und der ersten, zweiten und dritten Funktionsgleichung im Bezugssystem der Totalstation durch die Kontrolleinrichtung und
- Speichern der Zuordnung als Transformationsfunktion zwischen dem Bezugssystem der Totalstation und dem Bezugssystem des CAD-Modells.

Die Registrierung der Totalstation im Bezugssystem des CAD-Modells erfolgt ohne Kontrollpunkte. Im CAD-Modell werden vom Bediener drei Flächen ausgewählt, die nicht-parallel sind und deren zugehörige Ebenen sich in einem Schnittpunkt schneiden. Die Auswahl der drei nicht-parallelen Flächen im CAD-Modell kann auch durch die Auswahl einer Ecke oder einer sonstigen Struktur, die drei nicht-parallele Flächen aufweist, erfolgen. Der Bediener richtet die Totalstation in einer Startposition und Startorientierung (Startpose) aus, in der die Distanzmesseinheit der Totalstation auf den Schnittpunkt der drei Ebenen ausgerichtet ist. Eine genaue Ausrichtung der Totalstation ist nicht erforderlich, da der Schnittpunkt selbst nicht vermessen wird.

Die Verknüpfung des Bezugssystems der Totalstation mit dem Bezugssystem des CAD-Modells erfolgt nicht über Kontrollpunkte und zwei Verteilungen, sondern über zwei Sätze von Ebenengleichungen. Die Ebenengleichungen im Bezugssystem des CAD-Modells können mit geringem Aufwand von der Kontrolleinrichtung aus dem CAD-Modell abgeleitet werden und die Ebenengleichungen im Bezugssystem der Totalstation werden mithilfe von Messpunkten bestimmt. Durch die Ausrichtung der Totalstation auf den Schnittpunkt der drei Ebenen und die anschließende Rotation der Totalstation um diese Drehachse ist sichergestellt, dass für jede der drei Ebenen Messpunkte erzeugt werden und mithilfe der Messpunkte entsprechende Ebenengleichungen im Bezugssystem der Totalstation bestimmt werden können.

Die Kontrolleinrichtung bestimmt aus den Ebenengleichungen im Bezugssystem des CAD-Modells und den Funktionsgleichungen im Bezugssystem der Totalstation mithilfe bekannter mathematischer oder numerischer Verfahren eine Zuordnung zwischen dem Bezugssystem der Totalstation und dem Bezugssystem des CAD-Modells und speichert diese Zuordnung als Transformationsfunktion. Die Transformationsfunktion zwischen dem Bezugssystem der Totalstation und dem Bezugssystem des CAD-Modells kann für verschiedene Koordinatentransformationen zwischen den Bezugssystemen genutzt werden.

In einer ersten bevorzugten Variante werden die Position und/oder die Orientierung der Totalstation im Bezugssystem des CAD-Modells bestimmt. Mithilfe der Transformationsfunktion können die Position und/oder die Orientierung der Totalstation in das Bezugssystem des CAD-Modells transformiert werden und die Pose (Position und Orientierung) der Totalstation ist im Bezugssystem des CAD-Modells bekannt.

In einer zweiten bevorzugten Variante werden Messkoordinaten, die mit der Totalstation im Bezugssystem der Totalstation gemessen wurden, in das Bezugssystem des CAD-Modells transformiert. Die Transformationsfunktion zwischen dem Bezugssystem der Totalstation und dem Bezugssystem des CAD-Modells kann genutzt werden, um Messkoordinaten in das CAD-Modell zu übertragen.

In einer dritten bevorzugten Variante werden Soll-Koordinaten, die im Bezugssystem des CAD-Modells bestimmt wurden, in das Bezugssystem der Totalstation transformiert. Die Transformationsfunktion zwischen dem Bezugssystem der Totalstation und dem Bezugssystem des CAD-Modells kann genutzt werden, um Soll-Koordinaten aus dem CAD-Modell in die Messumgebung zu übertragen. Beim Layout werden Koordinaten aus einem Plan (CAD-Modell) in die Messumgebung übertragen. Die Soll-Koordinaten können mithilfe der Transformationsfunktion in Winkelkoordinaten und Distanzkoordinaten für die Totalstation umgerechnet werden. Der Bediener nutzt ein reflektierendes Zielobjekt und wird mithilfe der Totalstation beim Auffinden der Koordinaten in der Messumgebung unterstützt.

## Ausführungsbeispiele

Ausführungsbeispiele der Erfindung werden nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematischer und/oder leicht verzerrter Form ausgeführt. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei gegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugzeichen verwendet.

Es zeigen:

FIG. 1      eine Totalstation, die in einer Messumgebung aufgestellt und mit einer Kontrolleinrichtung verbunden ist;

FIGN. 2A, B      die Totalstation (FIG. 2A) und die Kontrolleinrichtung mit einem CAD-Modell (FIG. 2B) im Detail;

FIGN. 3A, B      das CAD-Modell der Objekte (FIG. 3A) und die Messumgebung 11 mit der Totalstation 10; und

FIG. 4      die Messumgebung mit N Messpunkten.

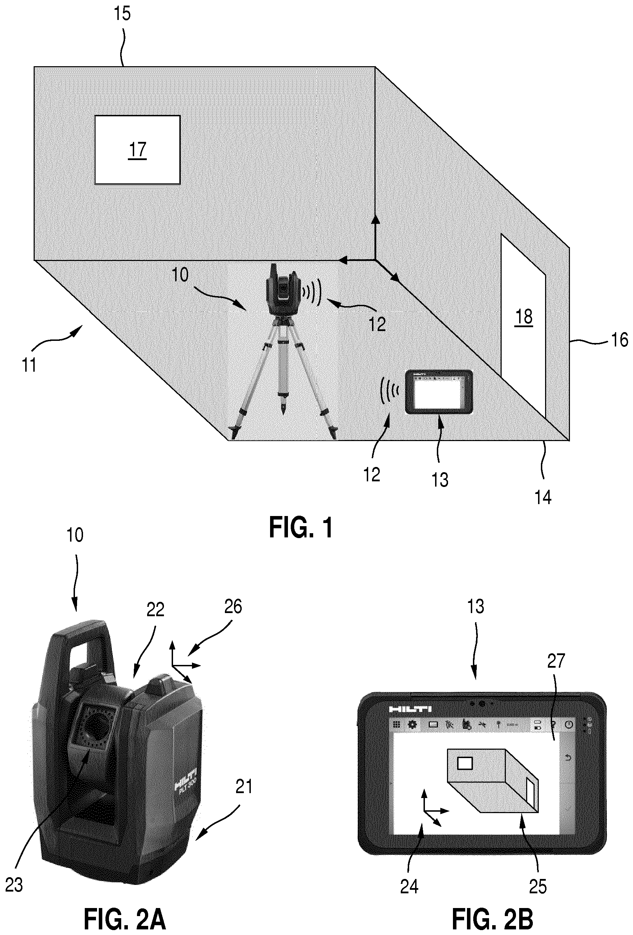

FIG. 1 zeigt eine Totalstation **10**, die in einer Messumgebung **11** aufgestellt ist und über eine Kommunikationsverbindung **12** mit einer Kontrolleinrichtung **13** verbunden ist. Die Messumgebung **11** ist im Ausführungsbeispiel als Innenraum ausgebildet, der von einer Bodenfläche **14**, einer Rückwand 15 und einer Seitenwand **16** begrenzt wird; die weiteren Begrenzungsflächen der Messumgebung **11** sind nicht dargestellt.

Die Messumgebung 11 weist mehrere Objekte auf. Zu den Objekten der Messumgebung 11 gehören die Bodenfläche 14, die Rückwand 15 und die Seitenwand 16 sowie eine Fensteraussparung **17** und eine Türaussparung **18**. Die Objekte 14, 15, 16, 17, 18 der Messumgebung sind in einem CAD-Modell abgebildet.

**FIGN. 2A**, **B** zeigen die Totalstation 10 (FIG. 2A) und die Kontrolleinrichtung 13 (FIG. 2B) der FIG. 1 im Detail. Die Totalstation 10 und die Kontrolleinrichtung 13 sind über die Kommunikationsverbindung 12 miteinander verbunden.

Die Totalstation 10 umfasst eine erste Winkelmesseinheit **21**, die einen Horizontalwinkel misst, eine zweite Winkelmesseinheit **22**, die einen Vertikalwinkel misst, und eine Distanzmesseinheit **23**, die eine Distanz misst. Um die Totalstation 10 zum Layouten einsetzen zu können, muss die Totalstation 10 im Bezugssystem **24** des CAD-Modells **25** registriert werden, d.h. die Transformationsfunktion zwischen dem Bezugssystem **26** der Totalstation 10 und dem Bezugssystem 24 des CAD-Modells 25 muss bestimmt werden.

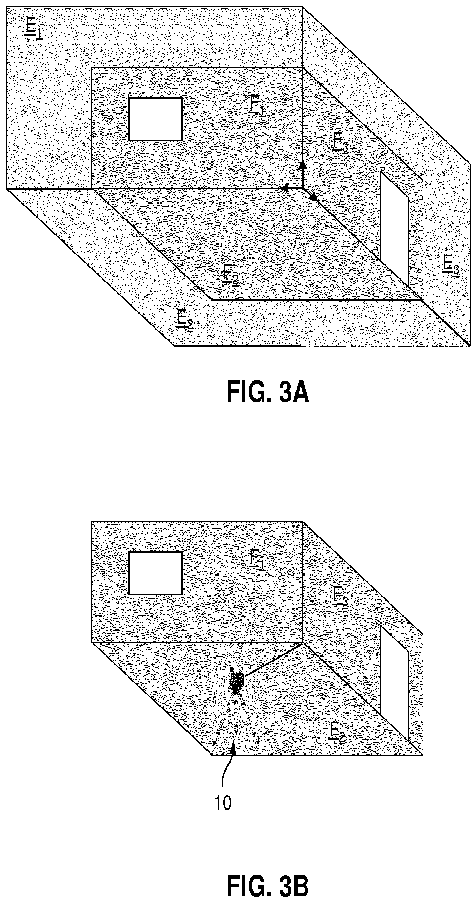

Die Durchführung des erfindungsgemäßen Verfahrens zur Registrierung der Totalstation 10 im Bezugssystem 24 des CAD-Modells 25 wird von der Kontrolleinrichtung 13 gesteuert. Das CAD-Modell 25 der Objekte ist in die Kontrolleinrichtung 13 geladen und wird auf einem Display **27** der Kontrolleinrichtung 13 angezeigt. **FIGN. 3A,** B zeigen das CAD-Modell 25 der Objekte (FIG. 3A) und die Messumgebung 11 mit der Totalstation 10 (FIG. 3B).

Der Bediener wählt im CAD-Modell 25 drei Flächen aus und markiert diese Flächen. Im Ausführungsbeispiel bildet die Oberfläche der Rückwand 15 eine erste Fläche $F_1$, die Oberfläche der Bodenfläche 14 eine zweite Fläche $F_2$ und die Oberfläche der Seitenwand 16 eine dritte Fläche $F_3$. Für das erfindungsgemäße Verfahren ist wesentlich, dass die drei Flächen $F_1$, F2, F3 nicht-parallel zueinander angeordnet sind. Diese Bedingung wird mathematisch dadurch berücksichtigt, dass die Normalenvektoren der drei Flächen $F_1$, $F_2$, $F_3$ einen dreidimensionalen Raum aufspannen.

Die Kontrolleinrichtung 13 bestimmt eine erste Ebene $E_1$, die die erste Fläche $F_1$ umfasst, eine zweite Ebene $E_2$, die die zweite Fläche $F_2$ umfasst, und eine dritte Ebene $E_3$, die die dritte Fläche $F_3$ umfasst. Die Lage einer Ebene ist im dreidimensionalen Raum durch einen Punkt und die Angabe des Normalenvektors eindeutig bestimmt. Alternativ kann die Lage einer Ebene beispielsweise durch drei Punkte festgelegt werden. Die Kontrolleinrichtung 13 generiert eine erste Ebenengleichung für die erste Ebene $E_1$, eine zweite Ebenengleichung für die zweite Ebene $E_2$ und eine dritte Ebenengleichung für die dritte Ebene $E_3$.

Um die Totalstation 10 mit Hilfe des erfindungsgemäßen Verfahrens im Bezugssystem des CAD-Modells zu registrieren, wird die Totalstation 10 in der Messumgebung 11 auf den Schnittpunkt der ersten, zweiten und dritten Ebene $E_1$, $E_2$, $E_3$ im CAD-Modell ausgerichtet (FIG. 3B). Diese Ausrichtung der Totalstation 10 wird von der Kontrolleinrichtung 13 als Startpose definiert. Die Startpose umfasst eine Startposition und eine Startorientierung. Die Totalstation 10 rotiert um die Startorientierung der Startpose als Drehachse und führt während der Rotation N, $N \in \mathbb{N}$ verschiedene Messungen aus. Bei jeder Messung wird von der ersten Winkelmesseinheit 21 ein Horizontalwinkel, von der zweiten Winkelmesseinheit 22 ein Vertikalwinkel und von der Distanzmesseinheit 23 eine Distanz gemessen. Im Ausführungsbeispiel wird während der Rotation der Totalstation 10 eine Anzahl von N = 19 verschiedenen Messungen ausgeführt.

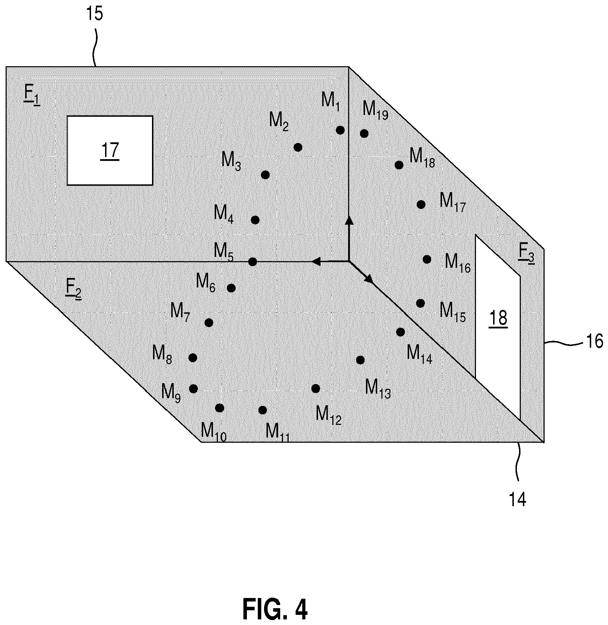

FIG. 4 zeigt die N = 19 verschiedenen Messungen. Zu jeder Messung wird ein Messpunkt $M_i$, $i \in \mathbb{N}$ mit zugehörigen Messkoordinaten definiert, wobei die Messkoordinaten jeweils einen Horizontalwinkel, einen Vertikalwinkel und eine Distanz umfassen. Im nächsten Schritt werden die Messpunkte $M_i$ von der Kontrolleinrichtung 13 der ersten Ebene $E_1$, der zweiten Ebene $E_2$ oder der dritten Ebene $E_3$ zugeordnet. Die Messpunkte $M_1$ bis $M_4$ werden der ersten Ebene $E_1$ zugeordnet und als erste Messpunkte definiert, die Messpunkte $M_6$ bis $M_{14}$ werden der zweiten Ebene $E_2$ zugeordnet und als zweite Messpunkte definiert und die Messpunkte $M_{15}$ bis $M_{19}$ werden der dritten Ebene $E_3$ zugeordnet und als dritte Messpunkte definiert. Der Messpunkt $M_5$ liegt auf der Schnittlinie zwischen der ersten Ebene $E_1$ und der zweiten Ebene $E_2$ und kann weder der ersten Ebene $E_1$ noch der zweiten Ebene $E_2$ eindeutig zugeordnet werden.

Nach der Zuordnung der Messpunkte $M_i$ zur ersten, zweiten oder dritten Ebene bestimmt die Kontrolleinrichtung 13 aus den ersten Messpunkten eine erste Funktionsgleichung für eine erste Ebene im Bezugssystem 26 der Totalstation 10, aus den zweiten Messpunkten eine zweite Funktionsgleichung für eine zweite Ebene im Bezugssystem 26 der Totalstation 10 und aus den dritten Messpunkten eine dritte Funktionsgleichung für eine dritte Ebene im Bezugssystem 26 der Totalstation 10. Die Genauigkeit, mit der die Kontrolleinrichtung 13 die Funktionsgleichungen (erste, zweite und dritte Funktionsgleichung) im Bezugssystem 26 der Totalstation 10 bestimmen kann, hängt ab von der Anzahl der jeweiligen Messpunkte $M_i$ und der Genauigkeit, mit der die Messpunkte $M_i$ bestimmt wurden.

In der Kontrolleinrichtung 13 sind für die erste, zweite und dritte Ebene erste, zweite und dritte Ebenengleichungen im Bezugssystem 24 des CAD-Modells 25 sowie erste, zweite und dritte Funktionsgleichungen im Bezugssystem 26 der Totalstation 10 gespeichert. Die Kontrolleinrichtung 13 bestimmt aus den Ebenengleichungen im Bezugssystem 24 des CAD-Modells 25 und den Funktionsgleichungen im Bezugssystem 26 der Totalstation 10 mithilfe bekannter mathematischer oder numerischer Verfahren eine Zuordnung zwischen dem Bezugssystem 26 der Totalstation 10 und dem Bezugssystem 24 des CAD-Modells 25 und speichert diese Zuordnung als Transformationsfunktion.

Die Transformationsfunktion zwischen dem Bezugssystem 26 der Totalstation 10 und dem Bezugssystem 24 des CAD-Modells 25 kann für verschiedene Koordinatentransformationen zwischen den Bezugssystemen 24, 26 genutzt werden. Beispielsweise können Messkoordinaten, die mit der Totalstation 10 im Bezugssystem 26 der Totalstation 10 gemessen wurden, in das Bezugssystem 24 des CAD-Modells 25 transformiert, oder Soll-Koordinaten, die im Bezugssystem 24 des CAD-Modells 25 bestimmt wurden, können in das Bezugssystem 26 der Totalstation 10 transformiert.

**Patentansprüche**

1. Verfahren zum Registrieren einer Totalstation (10), die in einer Messumgebung (11) mit einem oder mehreren Objekten (14, 15, 16, 17, 18) aufgestellt ist, im Bezugssystem (24) eines CAD-Modells (25), welches die Objekte (14, 15, 16, 17, 18) der Messumgebung (11) abbildet, durch eine Kontrolleinrichtung (13), mit den Schritten:

   ▪ Auswahl von drei Flächen ($F_1$, $F_2$, $F_3$) im CAD-Modell (25), wobei die Normalenvektoren der drei Flächen ($F_1$, $F_2$, $F_3$) einen dreidimensionalen Raum aufspannen,
   ▪ Bestimmen einer ersten Ebenengleichung für eine erste Ebene ($E_1$), die eine erste Fläche ($F_1$) der drei Flächen ($F_1$, $F_2$, $F_3$) umfasst, einer zweiten Ebenengleichung für eine zweite Ebene ($E_2$), die eine zweite Fläche ($F_2$) der drei Flächen ($F_1$, $F_2$, $F_3$) umfasst, und einer dritten Ebenengleichung für eine dritte Ebene ($E_3$), die eine dritte Fläche ($F_3$) der drei Flächen ($F_1$, $F_2$, $F_3$) umfasst, im Bezugssystem (24) des CAD-Modells (25) durch die Kontrolleinrichtung (13),
   ▪ Ausrichten der Totalstation (10) in der Messumgebung (11) auf den Schnittpunkt der ersten, zweiten und dritten Ebene ($E_1$, $E_2$, $E_3$) im CAD-Modell (25), wobei die Ausrichtung der Totalstation (10) von der Kontrolleinrichtung (13) als Startpose definiert wird,
   ▪ Rotieren der Totalstation (10) um die Drehachse der Startpose und Ausführen von N, $N \in \mathbb{N}$ verschiedenen Messungen während der Rotation der Totalstation (10), wobei bei jeder der N verschiedenen Messungen ein Horizontalwinkel von einer ersten Winkelmesseinheit (21), ein Vertikalwinkel von einer zweiten Winkelmesseinheit (22) und eine Distanz von einer Distanzmesseinheit (23) der Totalstation (10) gemessen wird,
   ▪ Speichern von N verschiedenen Messpunkten ($M_1$ - $M_{19}$) mit Messkoordinaten, wobei die Messkoordinaten den Horizontalwinkel, den Vertikalwinkel und die Distanz umfassen,
   ▪ Zuordnen von K der N, $K \leq N$ verschiedenen Messpunkte zur ersten Ebene ($E_1$), zur zweiten Ebene ($E_2$) oder zur dritten Ebene ($E_3$), wobei die der ersten Ebene ($E_1$) zugeordneten Messpunkte als erste Messpunkte, die der zweiten Ebene ($E_2$) zugeordneten Messpunkte als zweite Messpunkte und die der dritten Ebene ($E_3$) zugeordneten Messpunkte als dritte Messpunkte von der Kontrolleinrichtung (13) definiert werden,
   ▪ Bestimmen einer ersten Funktionsgleichung für die ersten Messpunkte, einer zweiten Funktionsgleichung für die zweiten Messpunkte und einer dritten Funktionsgleichung für die dritten Messpunkte im Bezugssystem (26) der Totalstation (10) durch die Kontrolleinrichtung (13),
   ▪ Bestimmen einer Zuordnung zwischen der ersten, zweiten und dritten Ebenengleichung im Bezugssystem (24) des CAD-Modells (25) und der ersten, zweiten und dritten Funktionsgleichung im Bezugssystem (26) der Totalstation (10) durch die Kontrolleinrichtung (13) und
   ▪ Speichern der Zuordnung als Transformationsfunktion zwischen dem Bezugssystem (26) der Totalstation (10) und dem Bezugssystem (24) des CAD-Modells (25).

2. Verfahren nach Anspruch 1, **dadurch gekennzeichnet, dass** die Position und/oder die Orientierung der Totalstation (10) im Bezugssystem (24) des CAD-Modells (25) bestimmt werden.

3. Verfahren nach Anspruch 1, **dadurch gekennzeichnet, dass** Messkoordinaten, die mit der Totalstation im Bezugssystem (26) der Totalstation (10) gemessen wurde, in das Bezugssystem (24) des CAD-Modells (25) transformiert werden.

4. Verfahren nach Anspruch 1, **dadurch gekennzeichnet, dass** Soll-Koordinaten, die im Bezugssystem (24) des CAD-Modells (25) bestimmt wurden, in das Bezugssystem (26) der Totalstation (10) transformiert werden.

**FIG. 1**

**FIG. 2A**

**FIG. 2B**

**FIG. 3A**

**FIG. 3B**

FIG. 4

Europäisches
Patentamt

European
Patent Office

Office européen
des brevets

# EUROPÄISCHER RECHERCHENBERICHT

Nummer der Anmeldung

EP 18 02 0521

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | FREDERIC BOSCHE: "Plane-based registration of construction laser scans with 3D/4D building models", ADVANCED ENGINEERING INFORMATICS, Bd. 26, Nr. 1, 24. August 2011 (2011-08-24), Seiten 90-102, XP028339511, Amsterdam ISSN: 1474-0346, DOI: 10.1016/J.AEI.2011.08.009 [gefunden am 2011-08-30] * whole document, in particular section 4 and Figs. 1 and 4 * ----- | 1-4 | INV. G01C15/00 G01S17/02 G06F17/50 G06K9/00 G06T19/00 |
| A | US 2013/096873 A1 (ROSENGAUS ELIEZER [US] ET AL) 18. April 2013 (2013-04-18) * Absätze [0036], [0075], [0103], [0104]; Abbildung 17 * ----- | 1-4 | |

RECHERCHIERTE SACHGEBIETE (IPC)

G01C
G01S
G06F
G06K
G06T

Der vorliegende Recherchenbericht wurde für alle Patentansprüche erstellt

| Recherchenort | Abschlußdatum der Recherche | Prüfer |
|---|---|---|
| Den Haag | 15. April 2019 | Philipp, Martine |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
  Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 18 02 0521

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-04-2019

| Im Recherchenbericht angeführtes Patentdokument | Datum der Veröffentlichung | Mitglied(er) der Patentfamilie | Datum der Veröffentlichung |
|---|---|---|---|
| US 2013096873 A1 | 18-04-2013 | TW 201337306 A<br>US 2013096873 A1<br>WO 2013059160 A1 | 16-09-2013<br>18-04-2013<br>25-04-2013 |

EPO FORM P0461

Für nähere Einzelheiten zu diesem Anhang : siehe Amtsblatt des Europäischen Patentamts, Nr.12/82